# EUROPEAN PATENT APPLICATION

(11) **EP 1 544 855 A1**
(43) Date of publication of application: **22.06.2005**
(21) Application number: 04300721.0
(22) Date of filing: 25.10.2004
(51) Int. Cl.: G11B 7/125, H01S 5/042, H01S 5/068, H01S 3/10

(54) **Compatible laser modulation circuit for scanner in optical storage media recording/reproducing apparatus**

(30) Priority: 15.12.2003 DE 10358957
(71) Applicant: Thomson Licensing S.A., 92100 Boulogne-Billancourt (FR)
(72) Inventor: Zucker, Friedhelm, 78052, Villingen-Schwenningen (DE)
(74) Representative: Rittner, Karsten, Dr.

(57) **Abstract**

The invention relates to a compatible optical scanner with an improved laser modulator for recording or reproduction apparatuses of optical recording media. Although the input characteristic curves of older and newer optical scanners fundamentally differ on account of different modulator circuits, a circuit arrangement for an optical scanner with an improved laser modulator is specified which is completely compatible with previously used optical scanners. The compatible scanner with an improved laser modulator, which is a laser modulator that at least partly or completely switches the laser current, has, at its input, a means for simulating the input characteristic curve of a laser, which means is formed for example by series-connected diodes D1...Dn or a zener diode that interacts with a current mirror at the input of the optical scanner. As a result, on the line providing the current for regulating the light power of a laser, a potential or a voltage corresponding to that of a laser is generated even though an improved laser modulator is connected. The potential or the voltage on the line is then used in a known manner, for example for changing over the sensitivity of a monitor diode used for regulating the light power of two different lasers. The area of application extends in particular to optical scanners in recording or reproduction apparatuses of optical recording media.

## Description

The invention relates to a compatible optical scanner with an improved laser modulator for recording or reproduction apparatuses of optical recording media. Although the input characteristic curves of older and newer optical scanners fundamentally differ on account of different modulator circuits, a circuit arrangement for an optical scanner with an improved laser modulator is specified which is completely compatible with previously used optical scanners.

Recording or reproduction apparatuses for optical recording media are generally known. Examples of such recording or reproduction apparatuses are CD or DVD players equipped by means of an optical scanning device, a so-called pick-up, to read data from an optical recording medium, a compact disc - abbreviated to CD - or a digital versatile disc - abbreviated to DVD. By means of a track regulating circuit, the pick-up is guided such that the light beam, a laser beam, that reads the data of an optical recording medium or writes data to the optical recording medium is guided on the data tracks of the optical recording medium. By means of a focus regulating circuit, the laser beam is focused onto the optical recording medium. The generic term servo regulating circuit is customary for the two regulating circuits - track regulating circuit and focus regulating circuit. By way of example, a twin laser with two laser diodes or two laser diodes for recording or reading data onto or from an optical recording medium are arranged on the pick-up. The laser diodes are connected by means of a flexible conductor strip to the circuits required for regulating the laser diodes and for signal processing, which are not arranged on the pick-up. In order to reduce the noise resulting from light coupled into the laser, the laser diodes are modulated, by means of a modulator, with a high-frequency signal that switches the laser on and off. In principle, two different methods have been disclosed for this purpose. Whereas in the past the bias current of the lasers has been modulated, so that the laser current has been increased and reduced with the modulation, in the meantime optical scanners that at least partly or completely directly switch the laser current have also been disclosed. Modulators of this type are referred to as improved laser modulators since they have a lower power loss and a range of further advantages. On account of the fundamentally different circuit concept, however, the improved laser modulators cannot, in principle, be used in conjunction with main circuit boards and circuit concepts that were developed for known optical scanners in which the bias current of the lasers is modulated even though the inputs of the improved laser modulator can be connected to the same outputs of the main circuit board that provide the bias current of the lasers for regulating the light power of the lasers. There is not complete compatibility since the outputs of the main circuit board carry different potential despite virtually corresponding regulation of the current for the provision of a constant light power of the laser.

It is an object of the invention to provide, with a low outlay, an optical scanner with an improved laser modulator which, despite a different circuit concept, is completely compatible with an optical scanner in which the bias current of the laser is modulated.

The invention achieves this object by providing an optical scanner with an improved laser modulator which has an input characteristic curve corresponding to the input characteristic curve of a laser. By virtue of the fact that the input characteristic curve of the optical scanner with an improved laser modulator has the characteristic of a laser, the optical scanner with an improved laser modulator, considered electrically with regard to its input, does not differ from an optical scanner in which the bias current of the laser is modulated, the desired compatibility of the optical scanner with an improved laser modulator being obtained as a result. The optical scanner with an improved laser modulator is distinguished by a range of advantages which, besides the lower power loss already mentioned, consist for example in better protection of the laser diode and reduced expenditure in the case of mounting and for avoiding radiofrequency interference. Since there is no longer a direct electrical connection between the flexible conductor strip via which the optical scanner is connected to its main circuit board and the laser diodes in the case of the optical scanner with an improved laser modulator, there is no longer the risk of the laser diodes or the terminals thereof being inadvertently touched and thereby destroyed. Short-circuiting bridges provided for the protection of the laser diodes are no longer necessary. Since the frequent and complicated soldering and unsoldering of the short-circuiting bridge is thereby obviated, fewer laser diodes are destroyed in the production process of the optical scanner. Damage to the flexible conductor strip on account of the soldering work is also avoided. The production and handling of the optical scanner is simplified, which leads to a cost reduction.

A further advantage to be mentioned is that a biasing current, a so-called bias, no longer has to be applied to the laser diodes. The laser diodes are therefore less sensitive to high temperatures and the power loss is reduced. Furthermore, the number of lines by which interference may be caused by electromagnetic fields is reduced, thereby reducing the number of required ferrite beads used as filters.

Although the inputs of the improved laser modulator can be connected to the same outputs of the main circuit board that provide the bias current of the lasers for regulating the light power of the lasers, there is not complete compatibility since the outputs of the main circuit board, with the laser connected and with the connection of an improved laser modulator, carry different potential despite virtually corresponding regulation of the current for the provision of a constant light power of the laser. This means that optical scanners with an improved laser modulator frequently cannot be used despite existing, but incomplete, compatibility. This applies in particular to optical scanners with modulation of the bias current, in the case of which the potential on the line that feeds the laser for regulating the light power of the laser is evaluated in order, by way of example, to change over the sensitivity of a monitor diode that is used jointly for two different lasers.

The different potential at the outputs of the main circuit board or on the lines that provide the current for regulating the light power of the laser is attributable to the different characteristic which the improved laser modulator has despite corresponding regulation of the current from the main circuit board for a constant light power of the lasers in comparison with a laser diode. In order that the input characteristic curve of the optical scanner with an improved laser modulator is adapted completely, or else with regard to the potential, to the input characteristic curve of an optical scanner in which the bias current of the laser is modulated, means which, in interaction with a current mirror, simulate the input characteristic curve of a laser are provided at the input of the optical scanner with an improved laser modulator. Since an optical scanner with an improved laser modulator generally already has a current mirror at its control input, a few diodes arranged in the forward direction or a zener diode already suffice to produce complete compatibility. The current mirror forming the input of the optical scanner with an improved laser modulator is provided in particular for ensuring a compatibility with the current control for regulating the light power of the laser and for avoiding perturbing effects on a current source that feeds the improved laser modulator.

A series circuit of diodes or a zener diode whose forward voltage corresponds to the operating voltage at a laser is provided at the input of the optical scanner with an improved laser modulator. The operating voltage of the laser is the voltage of the laser when the threshold current or forward current at which the laser activity commences is exceeded.

In the case of an optical scanner with an improved laser modulator, the input voltage varies approximately proportionally with the current fed to the improved laser modulator for regulating the light power of the laser. In this case, the input voltage has a relatively small rise. In the case of a laser, the voltage rises greatly even in the case of a small current, so that the voltage or the potential at the outputs of the main circuit board or on the lines that provide the current for regulating the light power of the laser is often used for switching the sensitivity of the monitor diode. This ensures that the monitor diode has a sensitivity corresponding to the laser power to be set and prevents destruction of the laser on account of incorrect assignment. In order to ensure this behavior and thus a complete compatibility also for an optical scanner with an improved laser modulator, one or more diodes in a series circuit with a forward voltage or a zener diode in the reverse direction with a zener voltage which corresponds to the operating voltage of a laser is or are provided at the input of the optical scanner with an improved laser modulator. What is thereby achieved is that the voltage or the potential at the outputs of the main circuit board or on the lines that provide the current for regulating the light power of the laser also varies in the case of an optical scanner with an improved laser modulator by analogy with a connected laser diode. On account of the thus completely produced compatibility, optical scanners with an improved laser modulator can also be used in connection with circuit concepts for optical recording or reproduction apparatuses that were and are being developed for optical scanners with modulation of the bias current of the laser diode.

The invention is explained in more detail below with reference to exemplary embodiments in figures, in which:
- Figure 1: shows a schematic diagram for the connection of an optical scanner with an improved laser modulator to a main circuit board,
- Figure 2: shows a schematic diagram for the connection of an optical scanner with modulation of the bias current to a main circuit board,
- Figure 3: shows a circuit arrangement of an optical scanner with bias current modulation,
- Figure 4: shows a circuit arrangement of an optical scanner with an improved laser modulator,
- Figure 5: shows a circuit arrangement for simulating the input characteristic curve of a laser,

- Figure 6: shows a current/voltage characteristic curve of the input of an improved laser modulator, and
- Figure 7: shows a current/voltage characteristic curve similar to a laser.

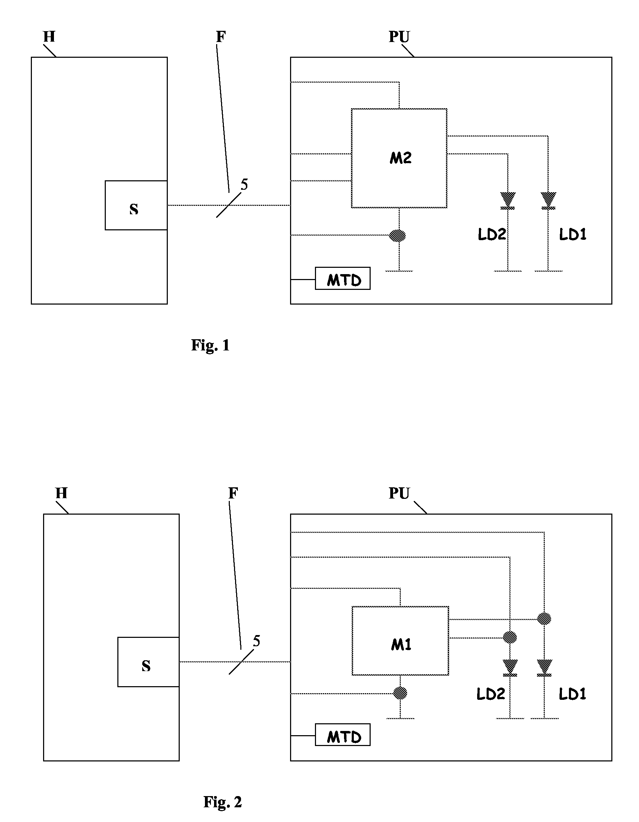

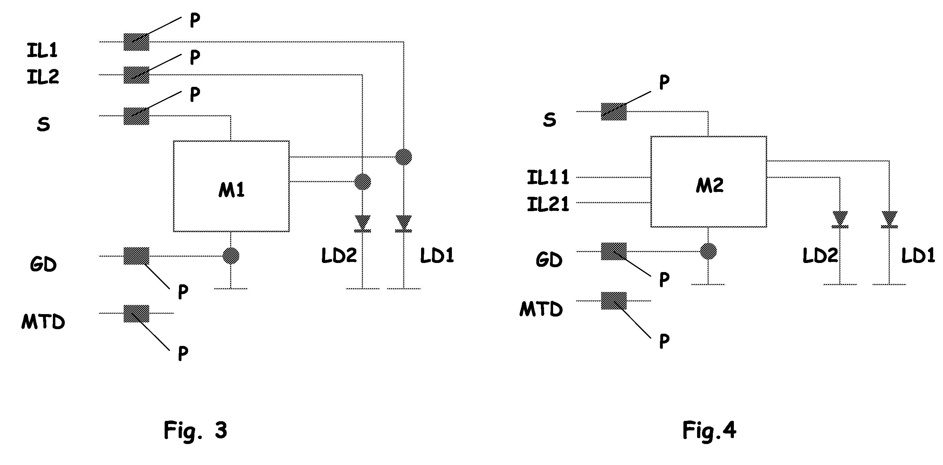

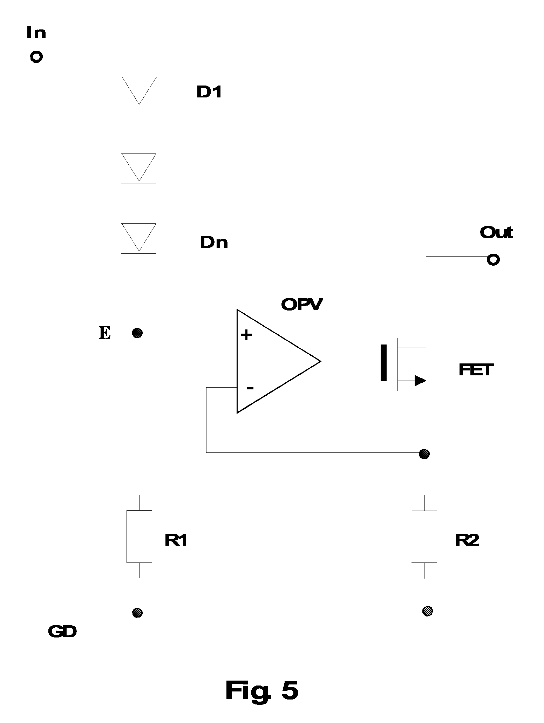

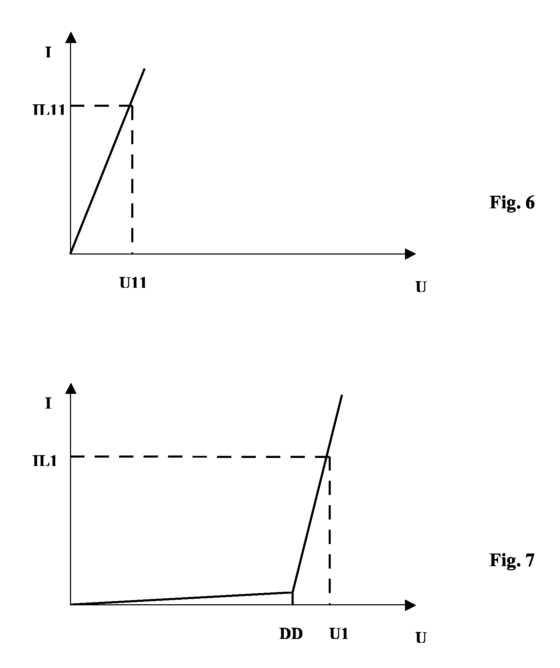

Reference symbols are used concordantly in the figures. A main circuit board H and the optical scanner PU with an improved laser modulator, said optical scanner also being referred to as a pick-up, are illustrated in a schematic diagram in Figure 1. Arranged on the main circuit board H, which is often also referred to as the mainboard, are circuits S for regulating and controlling the laser diodes or lasers LD1 and LD2 of the optical scanner PU and also for signal processing. Via a flexible conductor strip F, which is specified here only with the five lines required for the laser regulation, said circuits S are connected to the optical scanner PU having an improved laser modulator M2. In principle, such an optical scanner PU is already compatible with an optical scanner PU with modulation of the bias current as illustrated in Figure 2, since both the light power of the laser diodes LD1, LD2 of the optical scanner PU with an improved laser modulator M2 in accordance with Figure 1 and the light power of the laser diodes LD1, LD2 of the optical scanner PU with modulation of the bias current in accordance with Figure 2 are regulated with a current that is provided via the flexible conductor strip F. Nevertheless, there is not complete compatibility, since the outputs of the main circuit board H and lines of the flexible conductor strip F carry different potential despite corresponding regulation of the current for the provision of a constant light power of the lasers LD1, LD2. This has meant that optical scanners PU with an improved laser modulator M2 often cannot be used despite existing, but incomplete, compatibility. This applies in particular to main circuit boards H and optical scanners PU in the case of which the potential on a line that feeds the laser LD1 or LD2 is evaluated in order, by way of example, to change over the sensitivity of a monitor diode MTD that is used jointly for two different lasers LD1, LD2. The different potential at the outputs of the main circuit board H or on the lines of the main circuit board H that provide the current for regulating the light power of the lasers LD1, LD2 is attributable to the different circuit concepts on which the optical scanners PU or the control of the lasers LD1, LD2 are or is based. The different circuit concepts are illustrated in Figures 3 and 4, Figure 3 showing a circuit arrangement of an optical scanner PU with bias current modulation and Figure 4 showing a circuit arrangement of an optical scanner PU with an improved laser modulator M2. Although the main circuit board H provides the different optical scanners PU correspondingly with currents IL1 and IL12, respectively, and IL2 and IL22, respectively, for regulating the light power of the laser diodes LD1 and LD2, they have a different potential. The different potential results from the fact that the current provided by the main circuit board H for regulating the light power of the laser diodes LD1, LD2 is fed to the laser diodes LD1, LD2 directly in the case of the scanner PU with bias current modulation and to the laser modulator M2 in the case of the scanner PU with an improved laser modulator M2. In the case of the optical scanner PU with bias current modulation, for noise reduction the laser current IL1, IL2 is modulated with a high-frequency signal provided by a modulator M1, while the improved laser modulator M2 at least partly or completely directly switches the laser current with the laser modulator M2. By virtue of the fact that the connecting lines for regulating the light power of the lasers LD1 and LD2, in the case of the optical scanner PU with an improved laser modulator M2, are not connected directly to the laser diodes LD1 and LD2, the potential of these lines differs, as shown by the characteristic curves which are illustrated in Figure 6 and 7 and illustrate the profile of the current I against the voltage U. On account of the different characteristics of the inputs of the optical scanners PU, the identical current IL11 and IL1, respectively, with which the light power of the laser LD1 is regulated leads to different potentials or to a significantly lower voltage U11 in the case of the optical scanner PU with an improved laser modulator M2 in comparison with the voltage U1 in the case of the optical scanner PU with bias current modulation. The rise in the voltage U in the case of the optical scanner PU with an improved laser modulator M2 is too small to enable it to be used for example for changing over the sensitivity of the monitor diode MTD. In order nevertheless to be able to utilize the numerous advantages of an optical scanner PU with an improved laser modulator M2, which, besides a lower power loss, consist in better protection of the laser diodes LD1, LD2 and reduced expenditure in the case of mounting and for avoiding radiofrequency interference, means that result in complete compatibility being achieved are provided. A comparison of the circuit arrangements of the optical scanners PU that are illustrated in Figures 4 and 5 already shows a reduction of the number of ferrite beads P which is necessary in the case of the optical scanner PU with an improved laser modulator M2 for shielding against radiofrequency interference. At the inputs that are fed the current IL11 and IL21, optical scanners PU with an improved laser modulator M2 generally have a current mirror, so that complete compatibility can already be produced with a low outlay. For this purpose, as is shown on the basis of an exemplary embodiment illustrated in Figure 5, provision is made of a series circuit of diodes D1...Dn that is connected upstream of the current mirror. The current mirror is formed for example with an operational amplifier OPV and a field-effect transistor FET, the noninverting input + of the operational amplifier OPV forming, in a customary manner, the input E of the improved laser modulator M2 that is fed the current IL11 or IL22 for regulating the light power of the laser LD1 or LD2, respectively. Connected upstream of said input E, which is terminated by means of a first resistor R1 with respect to a line carrying reference-ground potential GD, is the series circuit of the diodes D1...Dn, which forms an input In of the completely compatible optical scanner PU with an improved laser modulator M2.

The diodes D1...Dn are connected in the forward direction and their series circuit is chosen in such a way that the forward voltage DD of the diodes D1...Dn corresponds to the operating voltage of the laser LD1 or LD2. The operational amplifier OPV drives a field-effect transistor FET, the source of which is connected to the inverting input - of the operational amplifier OPV and, via a second resistor R2, to the line carrying reference-ground potential GD. The drain of the field-effect transistor FET forms the output Out of the current mirror that is provided for controlling the light power of a laser LD1 or LD2. What is achieved by means of the diodes D1...Dn provided at the input of the current mirror is that, likewise in the case of an optical scanner PU with an improved laser modulator M2, the potential or the voltage U on the line providing the current for controlling the light power of a laser LD1 or LD2 behaves similarly to if a laser LD1 or LD2 were connected. The characteristic curve of a laser LD1 or LD2 is simulated, with a low outlay, at the input In of the optical scanner PU with an improved laser modulator M2. A particular contribution is made to this by the forward DD of the diodes D1...Dn, which is specified in Figure 7 and is chosen in a manner corresponding to the operating voltage of a laser LD1 or LD2, the operating voltage being a voltage of the laser when the threshold current or forward current from which laser activity commences is exceeded. The diodes D1...Dn may be arranged on the optical scanner PU, integrated into the improved laser modulator M2, or else on the main circuit board H of the recording or reproduction apparatus for optical recording media. Considered electrically, owing to the input In simulating the laser input characteristic curve, circuits S arranged on the main circuit board H see a laser even though the improved laser modulator M2 is what is actually involved. The optical scanner PU according to the invention is therefore compatible with all customary recording and reproduction apparatuses. The frequent soldering and unsoldering of the short-circuiting bridge is obviated and few laser diodes LD1, LD2 are destroyed during mounting and handling of the optical scanner PU.

The embodiment described here is specified only as an example and a person skilled in the art can realize other embodiments of the invention which remain within the scope of the invention since, in an exemplary embodiment that is not illustrated, the diodes D1...Dn are replaced by a zener diode or a circuit arrangement that deviates from a current mirror may be used for simulating the input characteristic curve of a laser LD1 or LD2 at the input of the improved laser modulator M2.

## Claims

1. A compatible optical scanner (PU) with an improved laser modulator (M2) for recording or reproduction apparatuses of optical recording media, wherein the optical scanner (PU) with an improved laser modulator (M2) is a laser modulator (M2) that at least partly or completely switches the laser current, and a means for simulating the input characteristic curve of a laser (LD1 or LD2) is provided at its input (E).

2. The compatible optical scanner (PU) as claimed in claim 1, wherein the means for simulating the input characteristic curve of a laser (LD1 or LD2) is a circuit arrangement that interacts with a current mirror of the optical scanner (PU), said current mirror being provided for regulating the light power of a laser (LD1 or LD2).

3. The compatible optical scanner (PU) as claimed in claim 2, wherein the current mirror of the optical scanner (PU) that is provided for regulating the light power of a laser (LD1 or LD2) is an operational amplifier (OPV) driving a field-effect transistor (FET), the noninverting input (+) of which amplifier is connected to a line carrying reference-ground potential (GD) via a first resistor (R1), the inverting input (-) of the operational amplifier (OPV) and the source of the field-effect transistor (FET) being connected to said line via a second resistor (R2), and the drain of the field-effect transistor (FET) is an output (Out) provided for regulating the light power of a laser (LD1 or LD2).

4. The compatible optical scanner (PU) as claimed in claim 1, wherein a series circuit of diodes (D1...Dn) that is connected upstream of a current mirror of the optical scanner (PU) that is provided for regulating the light power of a laser (LD1 or LD2) is provided for simulating the input characteristic curve of a laser (LD1 or LD2).

5. The compatible optical scanner (PU) as claimed in claim 1, wherein a zener diode that is connected upstream of a current mirror of the optical scanner (PU) that is provided for regulating the light power of a laser (LD1 or LD2) is provided for simulating the input characteristic curve of a laser (LD1 or LD2).

6. The compatible optical scanner (PU) as claimed in claim 4, wherein the diodes (D1...Dn) form a series circuit of diodes (D1...Dn) arranged in the forward direction with a forward voltage (DD) corresponding to the operating voltage of a laser (LD1 or LD2).

7. The compatible optical scanner (PU) as claimed in claim 5, wherein a zener diode with a zener voltage corresponding to the operating voltage of a laser (LD1 or LD2) is provided.

8. The compatible optical scanner (PU) as claimed in claim 1, wherein the means for simulating the input characteristic curve of a laser (LD1 or LD2) is arranged on the optical scanner (PU).

9. The compatible optical scanner (PU) as claimed in claim 1, wherein the means for simulating the input characteristic curve of a laser (LD1 or LD2) is integrated in the improved laser modulator (M2).

10. The compatible optical scanner (PU) as claimed in claim 1, wherein the means for simulating the input characteristic curve of a laser (LD1 or LD2) is arranged on a main circuit board (H) of the recording or reproduction apparatus of optical recording media, said main circuit board providing the current (IL11, IL21) for regulating the light power of a laser (LD1 or LD2).
